(19) Europäisches Patentamt
European Patent Office
Office européen des brevets

(11) **EP 2 736 076 A1**

(12) **EUROPEAN PATENT APPLICATION**

(43) Date of publication:
**28.05.2014 Bulletin 2014/22**

(51) Int Cl.:
*H01L 27/32* (2006.01)　　　*H05K 3/28* (2006.01)

(21) Application number: **12194080.3**

(22) Date of filing: **23.11.2012**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**

(71) Applicant: **Nederlandse Organisatie voor Toegepast -Natuurwetenschappelijk Onderzoek TNO 2628 VK Delft (NL)**

(72) Inventors:
• **van Lammeren, Tim Johannes 2628 VK Delft (NL)**

• **Hendriks, Rob Jacob 2628 VK Delft (NL)**
• **Rubingh, Eric 2628 VK Delft (NL)**
• **Wouters, Jurgen Cornelis Hubertus 2628 VK Delft (NL)**
• **Coenen, Erica Wilhelmina Catharina 2628 VK Delft (NL)**
• **Abbel, Robert J. 2628 VK Delft (NL)**

(74) Representative: **Jansen, Cornelis Marinus V.O. Johan de Wittlaan 7 2517 JR Den Haag (NL)**

(54) **Apparatus and method for manufacturing a layered product**

(57)　A method is disclosed of manufacturing a layered product. The method comprises the subsequent steps of
- providing (S1) a carrier (SB) with a first layer (L1) of a first material that is arranged according to a pattern L11, L12, L13,
- covering (S2) the carrier (SB) provided with the patterned first layer (L1) with a second layer (L2) of a second material,
- applying (S3) electro-magnetic radiation that is selectively absorbed in the first material, said absorption resulting in a heat development in the first material, which heat causes a curing of second material adjacent the first material (L21, L22, L23),
- removing (S4) non-cured second material.

FIG. 1C

Printed by Jouve, 75001 PARIS (FR)

## Description

BACKGROUND OF THE INVENTION

<u>Field of the invention</u>

The present invention relates to a method for manufacturing a layered product.

The present invention further relates to an apparatus for manufacturing a layered product.

<u>Related Art</u>

In many applications, patterned layers of functional materials have to be stacked

precisely on top of each other in order to achieve the desired functionality of the produced device. Furthermore, frequently it is necessary that the upper layer covers the

underlying material completely, so that the underlying layer is fully shielded. In particular this applies to the case where the underlying layer is a conductive layer and the shielding layer comprises an insulating material for insulating the conductive layer.

Shielding may also be necessary to prevent electro-migration. Electromigration is an electrochemical process where metal on an insulating material, in a humid environment and under an applied electric field, leaves its initial location in ionic form and redeposits somewhere else. Such migration may reduce isolation gaps and ultimately lead to an electrical short circuit.

Silver is the metal most susceptible to migration, since it is anodically very soluble and requires a low activation energy to initiate the migration process. Copper, zinc, and lead will also migrate, although only under much more severe conditions. Most other common electronic materials are not susceptible to migration: iron, nickel, and tin because of their low solubility in water; gold, platinum, and palladium because they are anodically stable.

According to one known method (1) the upper layer is deposited on the first one by printing with a highly accurate registration.

According to another known method (2) the upper layer is deposited unselectively on the entire surface, and treated locally in such a way (e. g. by exposure to light through a mask)

that is only remains where it is desired. The undesired parts have to be removed afterwards. Both approaches require a process step in which the exact position of the first layer is determined, and subsequently require a localized treatment, either by selective

deposition (method 1), or a selective fixation treatment (method 2).

WO2012025847 discloses a self-aligned coverage of opaque conductive areas. According to this known method a transparent substrate is provided that is at least partly covered with a first layer stack comprising at least one transparent layer, preferably an electrically conductive layer, and a pattern of first and second opaque conductive areas deposited on top of the transparent layer. Subsequently a photoresist layer of an electrically insulating photoresist material is deposited on top of the first layer stack that at least fully covers the second opaque conductive areas. The photoresist layer is illuminated through the transparent substrate with light of a suitable wavelength to make the photoresist material soluble in the areas of the photoresist layer that have no opaque conductive areas underneath. The soluble areas of the photoresist layer are then removed. Subsequently the areas of the photoresist layer remaining on top of at least the second opaque conductive areas are heated to re-flow the photoresist layer to cover the edges of the second opaque conductive areas in contact to the transparent layer, and the remaining areas of the photoresist layer are hardened. It is a disadvantage of the known method that an additional re-flow step is necessary in order to achieve that the edges of the conductive areas are also covered with the insulating material.

SUMMARY OF THE INVENTION

It is an object of the invention to provide an improved method that does not have this disadvantage.

It is a further object of the invention to provide an improved apparatus capable of performing the method.

According to a first aspect of the present invention a method of manufacturing a layered product is provided that comprises the steps of

-   providing a carrier with a first layer of a first material that is arranged according to a pattern,
-   covering the carrier provided with the patterned first layer with a second layer of a second material,
-   applying electro-magnetic radiation that is selectively absorbed in the first material, said absorption resulting in a heat development in the first material which heat causes a curing of second material covering the first material,
-   removing non-cured second material.

According to a second aspect of the present invention an apparatus for manufacturing a layered product is provided, comprising a carrier feeding module, a deposition module, a treatment module, a removing module, a transportation module, and a control module for in an operative state of the apparatus causing

-   the carrier feeding module to provide a carrier with a first layer of a first material that is arranged according to a pattern,
-   the deposition module for covering the carrier provided with the patterned functional layer with a second material for a second layer,
-   the treatment module for applying electro-magnetic radiation that is selectively absorbed in the first material, said absorption resulting in a heat development in the first material which heat causes a curing of second material covering the first material,

- the removing module for removing the non-cured second material,
- the transportation module for subsequently transporting the carrier provided by the carrier feeding module to the deposition module, the treatment module and the removing module.

In the improved method and during operation of the apparatus according to the present invention a selective treatment occurs of second material that covers the first material. Accordingly, as a result of this treatment not only the second material that is stacked upon the first material is in a cured state, but also the remaining second material that covers the first material, such as the second material that laterally covers the first material. Therewith no reflow step is required in order to achieve that the second material fully and conformally covers the first material.

The thickness of the layer of second material can be well controlled by control of the intensity of the electro-magnetic radiation, a time during which the electro-magnetic radiation is applied and if desired a duty cycle.

This is in particular useful for manufacturing a layered product wherein the first patterned layer is of an electrically conductive material and the second patterned layer is of an insulating material that serves to insulate the first patterned layer.

Especially for lighting devices, such as OLEDs, this is important as the insulating material may serve as a shield that counteracts migration of electrically conductive material. However, the method and apparatus are also suitable for other applications wherein it is desired to form an insulating structure conformal to an electrically conductive structure, for example to form an electrically conducting bridges for an electrical conductor that crosses another electrical conductor in an electrically insulated manner.

In an embodiment the first patterned layer may have a relatively rough surface and the resulting second layer, although substantially conformal with the first patterned layer is relatively smooth.

BRIEF DESCRIPTION OF THE DRAWINGS

These and other aspects are described in more detail with reference to the drawing. Therein:

FIG. 1 shows an embodiment of a method according to the first aspect of the invention,
FIG. 2 shows measured thickness profiles of products obtained with said method,
FIG. 3 shows details of products obtained with the invention,
FIG. 4 shows simulation results,

FIG. 5 shows an apparatus according to the second aspect of the invention
FIG. 6 shows a detail of a further product obtained with the present invention.

DETAILED DESCRIPTION OF EMBODIMENTS

The figures are purely diagrammatic and not drawn to scale. Particularly for clarity, some dimensions are exaggerated strongly. Similar components in the figures are denoted by the same reference symbols as much as possible.

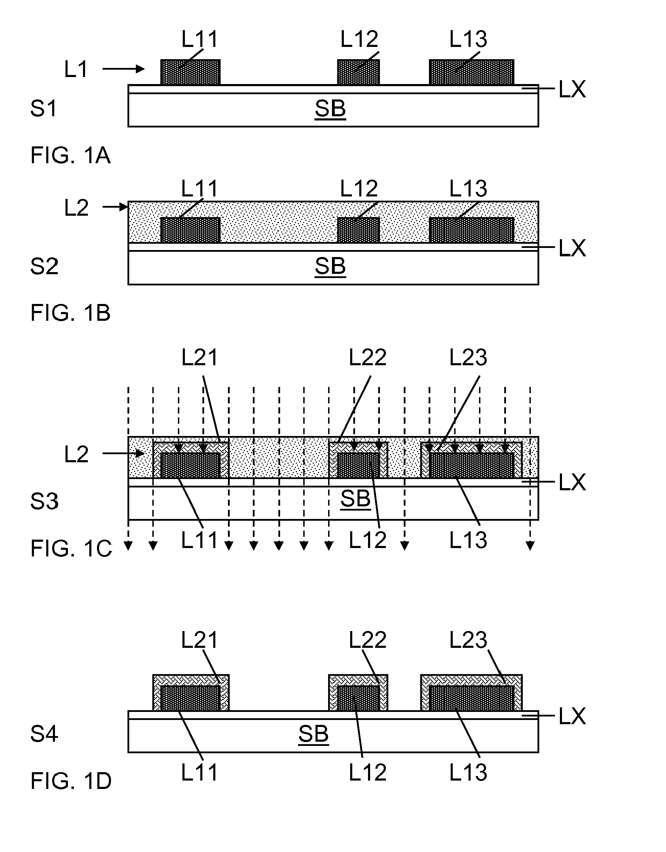

FIG. 1 shows a method of manufacturing a layered product, such as an electronic device, e.g. a light emitting device, such as an OLED or a data processing device.

FIG. 1A schematically shows a step (S1) of the method of providing a carrier with a first layer L1 of a first material that is arranged according to a pattern L11, L12, L13. A carrier typically comprises a substrate, such as a polymer foil or a glass plate. Optionally the carrier may include additional layers LX between the substrate SB and the first layer L1, as is shown here in FIG. 1A.

In a subsequent step (S2), shown in FIG. 1B, the carrier provided with the patterned first layer L1 is provided with a second layer L2 of a second material. From a point of view of production efficiency the layer L2 is preferably applied blanketwise as shown in FIG. 1B, so that a cheap and fast coating method can be used, e.g. spin-coating or slot die coating. Alternatively, the second layer may be applied in a pre-patterned way, so that it is approximately conformal to the pattern of the first layer L1, e.g. by printing.

In a subsequent step (S3), shown in FIG. 1C, electro-magnetic radiation is applied (indicated by dashed arrows) that is selectively absorbed in the first material. The absorption coefficient $\alpha$, also denoted as attenuation coefficient characterizes how easily the material can be penetrated by the radiation, according to the Beer-Lambert law.

$$I = I_0 e^{-\alpha x}$$

Therein $I/I_0$ is the ratio of the intensity of the radiation at depth x divided by the intensity of the radiation at the surface of the material. The selection of the spectrum of the electro-magnetic radiation to be applied is not relevant, provided that the absorption coefficient $\alpha$ of the first material is higher, preferably substantially higher than that of the second material. Accordingly, dependent on the available materials a line spectrum, a narrow band spectrum or a broad band spectrum, e.g. having a spectrum in the range of 400-1000 nm may be selected.

Typically the electro-magnetic radiation is photon-radiation. The selective absorption of the electro-magnetic radiation in the first material causes a heat development therein. This heat is conducted to portions L21, L22, L23 of the layer of second material that covers the first material and therewith causes a curing of these portions. As shown in FIG. 1C, the electro-magnetic radiation may be applied as an homogeneous beam, but it would be sufficient to restrict the beam, provided that the areas occupied by the pattern L11, L12, L13 is irradiated.

Although the electro-magnetic radiation is applied from the side of the semi-finished product carrying the layer L2, the electro-magnetic radiation may alternatively be applied from the other side, i.e. the carrier SB, provided that the latter has a sufficient transmission for the electro-magnetic radiation. In a subsequent step (S4) non-cured second material is removed, for example by dissolving the non-cured second material. Therewith the result of FIG. 1D is obtained, wherein the cured portions L21, L22, L23 of the layer of second material remain, and wherein these cured portions fully cover the pattern L11, L12, L13.

Although in this example the second layer L2 is applied directly upon the first layer, it is alternatively or additionally possible to apply the second layer L2 in the presence of one or more intermediate layers between the first layer L1 and the second layer L2, provide that the intermediate layer(s) provide for a sufficient thermal conductivity of heat developed in the first layer L1 towards the second layer.

An experiment was conducted to test the method described above. First a quartz-substrate, having a thickness of 1mm was provided with a pattern of silver structures. To that end a Fujifilm Dimatix DMP-2800 inkjet printer to print Suntronic U5603 - 20%wt Ag ink on the substrate. The ink was printed as lines having a width of about 40 $\mu$m and a height of about 400 - 350nm. The lines were subsequently sintered at 130° Celsius for 30 minutes. After the sintering of the silver structures, wet isolating ink (DuPont 3571) was deposited with a pipette to completely flood the printed features and the rest of the substrate surface. After depositing the dielectric material, the sample was placed in the Stand-Alone Photonic Sintering unit and exposed to a pulse wise operated broad band Xenon stroboscope lamp type Philips XOP15 providing radiation with an intensity of 500 W/cm$^2$. The pulse repetition rate was 50Hz and the pulse width was 8 ms. In this case two pulses were applied.

After curing, the excess wet isolating material was removed by dissolving in ethanol. The experiment was repeated with a PEN-foil having a thickness of 125 $\mu$m as the substrate.

It is noted that WO2010036116 by the same Applicant also describes various alternative methods to apply an electrically conductive structure. Other materials for use in the electrically conductive structure are copper, aluminum, carbon, gold, MAM, tin, etc.

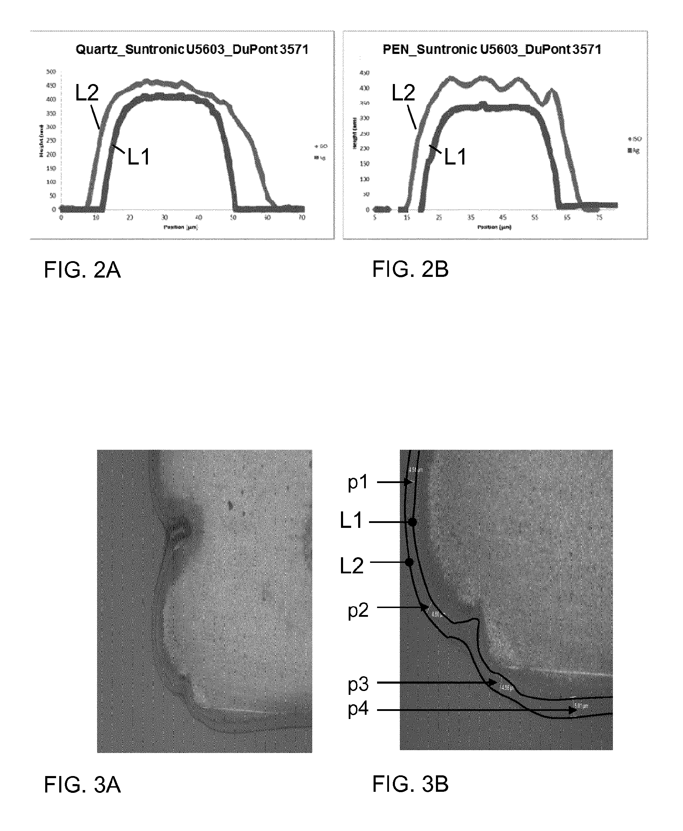

Instead of DuPont 3571 another heat curable precursor such as SU8 may be used. The profile of the layers L1 and L2 in the samples so obtained was measured with a DekTak profilometer. The profile of layer L1 formed by a silver line was measured after it was sintered and before the wet isolating ink was applied. The profile of layer L2 formed by the isolating material was measured after the step of dissolving excess isolating material. The results thereof are shown in FIG. 2A for the sample having the quartz substrate and in FIG. 2B for the sample having the PEN-foil as the substrate. It can be seen in FIG. 2A and 2B, that the layer L2 fully covers the layer L1, including the sides of layer L1.

FIG. 3A and 3B are microscope images showing a corner at an end of a silver line of a sample as prepared according to the procedure described above, using a quartz substrate. The magnification is 50 and 100 respectively. The images as prepared according to the procedure described above. FIG. 3B also shows respective measurements of the distance with which the upper layer L2 laterally extends beyond the lower layer L1. The measured distances at points p1, p2, p3, p4 are respectively: 4.51 $\mu$m, 4.66 $\mu$m, 4.56 $\mu$m, and 5.01 $\mu$m.

The radiation source and its settings may be adapted to the materials used. For example if in a wavelength band B the light attenuation ratio of the materials of the layers SB and L2 is particularly low in comparison to outside that band B, and further the material L1 has a good light absorption in that band B, then it is favorable to choose a radiation source predominantly emitting radiation in the wavelength band B.

Depending on the desired distance with which the upper layer L2 laterally extends beyond the lower layer L1, the total irradiation time or number of pulses may be varied. The irradiation time may be increased for example to increase this distance. Also the radiation power may be increased. However a too high radiation power may damage parts of the product, or may have the effect that curing occurs also in portions of the layer L2 that are not adjacent to features L11 in layer L1.

The power distribution over time may also be changed. For example for some applications it may be desired that the temperature is relatively constant during the irradiation step. This may be achieved by increasing the frequency.

In an embodiment the irradiation source is operated continuously.

Simulation results

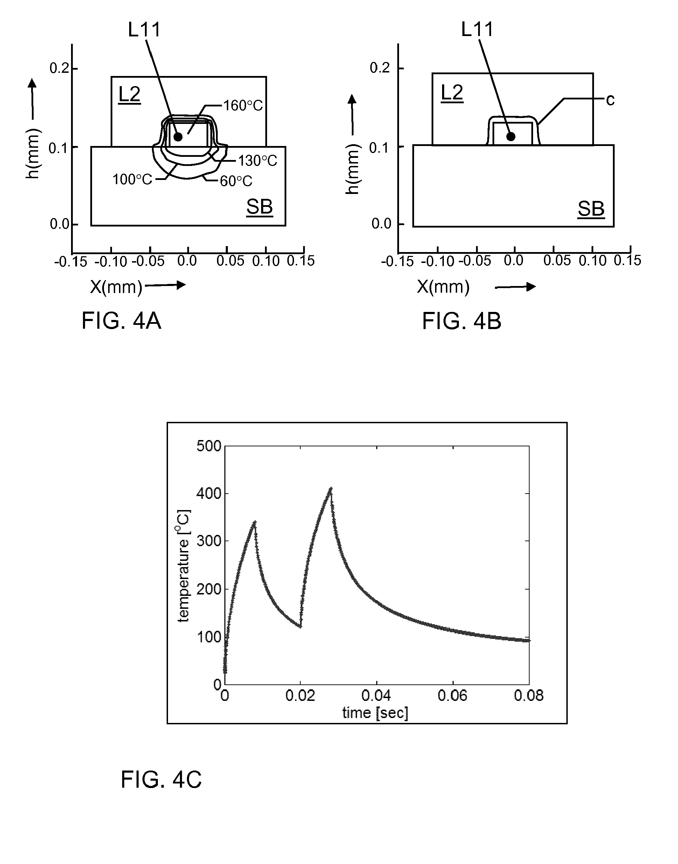

FIG. 4A, 4B, show results of a simulation of a situation wherein a substrate SB having at thickness of 100 $\mu$m is provided with a silver line L11 having a width of 50 $\mu$m and a height of 25 $\mu$m is covered with a layer L2 of a heat curable substance having a height of 100 $\mu$m. FIG. 4A, 4B Therein x indicates the horizontal position in mm with respect to a central position in the silver line L11 and h indicates the height also in mm, with respect to the lower face of the substrate SB.

The following material properties were presumed.

| Material | Cp(J/kgK) | ρ(kg/m³) | λ(W/mK) |
|---|---|---|---|
| SB(quartz) | 670 | 2200 | 1.4 |
| L11(Silver) | 235 | 10500 | 429 |
| L2(Resin) | 1600 | 1400 | 0.29 |

According to the simulation it is presumed that radiation is provided from the side of the substrate SB provided with the layers L1 and L2, as indicated in FIG. 1C, and that the intensity of the radiation is 500 W/cm². According to the simulation model the radiation is applied as a sequence of pulses, with a repetition rate of 50 Hz and a pulse width of 8 ms. In this case a total of two pulses was applied.

FIG. 4A shows with isothermal lines a temperature distribution obtained, wherein the silver line L11 is heated to 160 °C. FIG. 4B shows with the curve c the boundary of the volume around silver line L11, wherein the heat curable substance L2 is sufficiently cured to prevent that it is dissolved in the removing step.

FIG. 4C shows the temperature in the silver line L11 as a function of time. As a result of the first pulse the temperature therein rises to about 340 degrees and subsequently cools down to about 130 °C. The second pulse causes the temperature to rise to about 400 degrees °C. In this model it is presumed that the layer L2 and the substrate SB are fully transparent to the radiation, so that only the material in layer L1 is directly heated. Nevertheless, as demonstrated by the experiments described with reference to FIG. 2A, 2B and 3A, 3B above the method is applicable to common materials for the second layer L2 and the carrier SB which in practice do absorb the radiation to some extent, provided the absorption is substantially less than in the material of the first layer L1. In case materials are used for the second layer L2 and the carrier SB that absorb the radiation to some higher extent, these materials will also be heated in locations non-adjacent to the features L11, due to this absorption. In order to prevent that portions of the layer L2 in these non-adjacent locations are also cured, the following measures may be taken. The pulses may be applied at higher repetition rate, so that the temperature fluctuations during the irradiation step are reduced. Furthermore, the applied power density is at a level that insufficiently heats the non-adjacent portions of the material in layer L2 to cause curing, but that causes sufficiently additional indirect heating of the portions of layer L2 adjacent the features L11 due to the heat generated in those features and conducted to those adjacent portions.

It may be considered to provide the irradiation as a first pulse that rapidly heats the material in layer L1 to a desired temperature and a sequence of second pulses that maintain the temperature at said desired temperature.

It may also be considered to provide the irradiation continuously during a time interval. Also in that case the irradiation may have a relatively high intensity at the beginning of the time interval to rapidly heat the material in layer L1 to a desired temperature.

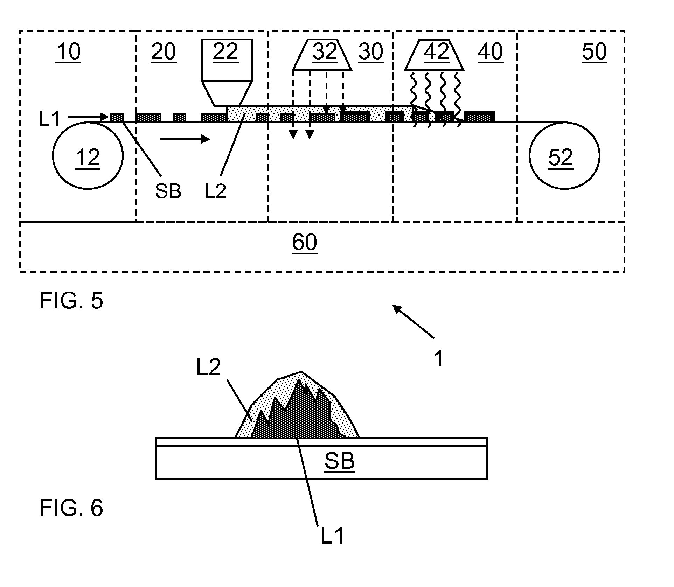

FIG. 5 schematically shows an apparatus 1 for manufacturing a layered product. The apparatus comprising a carrier feeding module 10, a deposition module 20, a treatment module 30, a removing module 40, a transportation module 12, 52, and a control module 60.

In an operative state of the apparatus the control module 60 causes the carrier feeding module 10 to provide a carrier with a first layer of a first material that is arranged according to a pattern. In the embodiment shown the carrier with the first layer of material as shown in FIG. 1A is provided a semi-finished product on a supply roll 12. Alternatively, the carrier feeding module may *in situ* prepare a carrier with a first layer of a first material. As indicated above, the first layer L1 may be preceded by intermediate layers Lx. Also, the carrier feeding module may have applied one or more further layers, e.g. a passivation layer, on the first layer L1, provided that these further layers sufficiently conduct heat from the first layer into the second layer to be applied by the deposition module 20.

In the operative state the control module 60 causes the deposition module 20 to cover the carrier provided with the patterned functional layer with a second material for a second layer, to obtain the semi-finished product as shown in FIG. 1B. Typically the deposition module may comprise a slot-die coating module 22 for this purpose. In case the method is applied in a sheet to sheet process, alternatively a spin-coating module may be used. Other common coating/printing processes may be used if desired.

In the operative state the control module 60 causes the treatment module 30 for applying electromagnetic radiation (indicated by dashed arrows) that is selectively absorbed in the first material. Absorption of the electro-magnetic radiation results in a heat development in the first material. This heat is conducted into the second material and therewith causes a curing of second material covering the first material, as depicted in FIG. 1C. In the embodiment shown the treatment module 30 comprises a photon radiation source 32 that provides for a substantial homogeneous illumination of the semi-finished product as delivered by the deposition module 20.

In the operative state the control module 60 causes the removing module 40 to remove the non-cured second material, therewith obtaining a result as shown for example in FIG. 1D. In the embodiment shown, the removing module 40 comprises a washing device 42 for washing the non-cured second material from the semi-finished product. In the embodiment shown, the product obtained after processing by the removing module is transported to a further apparatus module 50. The further apparatus module 50 for example comprises a storage roll 52. Alternatively, the further apparatus module 50 may apply further manufacturing steps, e.g. packaging, deposition of a barrier structure etc.

The control module 60 in operative state of the device further causes the transportation module to subsequently transport the carrier provided by the carrier feeding module to the deposition module, the treatment module and the removing module.

Fig. 6 shows how the method and apparatus according to the present invention can be used to apply the second layer L2 as a smoothing layer over the first layer L1. By heating the layer L1 for a sufficiently long, the heat developed in the first layer can penetrate sufficiently deep in the second layer L2, so that a sufficiently thick portion of the second layer is cured. Therewith the second layer L2, although macroscopically conformal to the first layer L1, is on a more detailed level smoother than the first layer L1.

It is noted that the above-mentioned embodiments illustrate rather than limit the invention, and that those skilled in the art will be able to design many alternative embodiments without departing from the scope of the appended claims.

In the claims, any reference signs placed between parentheses shall not be construed as limiting the claim. Use of the verb "comprise" and its conjugations does not exclude the presence of elements or steps other than those stated in a claim. The article "a" or "an" preceding an element does not exclude the presence of a plurality of such elements. The invention may be implemented by means of hardware comprising several distinct elements or by means of software. In the device claim enumerating several means, several of these means may be embodied by one and the same item of hardware. The mere fact that certain measures are recited in mutually different dependent claims does not indicate that a combination of these measures cannot be used to advantage.

**Claims**

1. A method of manufacturing a layered product, comprising the subsequent steps of

   - providing (S1) a carrier with a first layer of a first material that is arranged according to a pattern,
   - covering (S2) the carrier provided with the patterned first layer with a second layer of a second material,
   - applying (S3) electro-magnetic radiation that is selectively absorbed in the first material, said absorption resulting in a heat development in the first material, which heat causes a curing of second material adjacent the first material,
   - removing (S4) non-cured second material.

2. A method according to claim 1, wherein the first material is electrically conductive and wherein the second material is electrically insulating.

3. A method according to claim 2, wherein the first material is silver.

4. The method according to claim 1, wherein the first layer is applied by printing.

5. The method according to claim 1, wherein the electro-magnetic radiation is provided pulse wise.

6. An apparatus for manufacturing a layered product, comprising a carrier feeding module (10), a deposition module (20), a treatment module (30), a removing module (40), a transportation module (12, 52), and a control module (60) for in an operative state of the apparatus causing

   - the carrier feeding module (10) to provide a carrier (SB) with a first layer (L1) of a first material that is arranged according to a pattern,
   - the deposition module (20) to cover the carrier (SB) provided with the patterned first layer (L1 with a second material for a second layer (L2),
   - the treatment module (30) to apply electro-magnetic radiation that is selectively absorbed in the first material, said absorption resulting in a heat development in the first material which heat causes a curing of second material adjacent the first material,
   - the removing module (40) to remove the non-cured second material,
   - the transportation module (12, 52) to subsequently transport the carrier (SB) provided by the carrier feeding module (10) to the deposition module (20), the treatment module (30) and the removing module (40).

7. An apparatus according to claim 6, wherein the first material is an electrically conductive material.

8. An apparatus according to claim 6, wherein the treatment module comprises a microwave generator.

9. A computer program product comprising instructions for controlling manufacturing a layered product by an automated apparatus, said instructions comprising

   - first instructions for causing the apparatus to provide a carrier with a first layer of a first material that is arranged according to a pattern,
   - second instructions for subsequently causing the apparatus to cover the carrier provided with the patterned first layer with a second layer of a second material,
   - third instructions for subsequently causing the apparatus to apply electro-magnetic radiation

**EP 2 736 076 A1**

that is selectively absorbed in the first material, said absorption resulting in a heat development in the first material, which heat causes a curing of second material adjacent the first material,
- fourth instructions for subsequently causing the apparatus to remove non-cured second material.

EP 2 736 076 A1

L11    L12    L13

L1 →

LX

S1    SB

FIG. 1A

L11    L12    L13

L2 →

LX

S2    SB

FIG. 1B

L21    L22    L23

L2 →

LX

S3    SB

L11    L12    L13

FIG. 1C

L21    L22    L23

LX

S4    SB

L11    L12    L13

FIG. 1D

8

FIG. 2A

FIG. 2B

FIG. 3A

FIG. 3B

FIG. 4A

FIG. 4B

FIG. 4C

FIG. 5

FIG. 6

Europäisches
Patentamt

European
Patent Office

Office européen
des brevets

## EUROPEAN SEARCH REPORT

Application Number

EP 12 19 4080

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 4 379 833 A (CANAVELLO BENJAMIN J ET AL) 12 April 1983 (1983-04-12) | 6-9 | INV. H01L27/32 |
| A | * column 2, line 23 - column 3, line 34; figures 2.1-2.6 * | 1-5 | H05K3/28 |
| A | WO 2010/038181 A1 (PHILIPS INTELLECTUAL PROPERTY [DE]; KONINKL PHILIPS ELECTRONICS NV [NL] 8 April 2010 (2010-04-08) * page 4, line 25 - page 5, line 28; figures 2a,b * | 1-9 | |
| A | WO 2012/060260 A1 (FUJIFILM CORP [JP]; MINAMI KOICHI [JP]; SATOU MASATAKA [JP]; OGIKUBO S) 10 May 2012 (2012-05-10) * paragraphs [0014] - [0053]; figure 1 * | 1-9 | |

TECHNICAL FIELDS
SEARCHED      (IPC)

H01L
H05K
G03F
G02F

The present search report has been drawn up for all claims

| Place of search | Date of completion of the search | Examiner |
|---|---|---|
| The Hague | 25 April 2013 | Bakos, Tamás |

CATEGORY OF CITED DOCUMENTS

X : particularly relevant if taken alone
Y : particularly relevant if combined with another
document of the same category
A : technological background
O : non-written disclosure
P : intermediate document

T : theory or principle underlying the invention
E : earlier patent document, but published on, or
after the filing date
D : document cited in the application
L : document cited for other reasons

& : member of the same patent family, corresponding
document

EPO FORM 1503 03.82 (P04C01)

**ANNEX TO THE EUROPEAN SEARCH REPORT
ON EUROPEAN PATENT APPLICATION NO.**

EP 12 19 4080

This annex lists the patent family members relating to the patent documents cited in the above-mentioned European search report.
The members are as contained in the European Patent Office EDP file on
The European Patent Office is in no way liable for these particulars which are merely given for the purpose of information.

25-04-2013

| Patent document cited in search report | | Publication date | Patent family member(s) | | Publication date |
|---|---|---|---|---|---|
| US 4379833 | A | 12-04-1983 | DE | 3279612 D1 | 18-05-1989 |
| | | | EP | 0083397 A2 | 13-07-1983 |
| | | | JP | S58119640 A | 16-07-1983 |
| | | | US | 4379833 A | 12-04-1983 |
| WO 2010038181 | A1 | 08-04-2010 | CN | 102171851 A | 31-08-2011 |
| | | | EP | 2332194 A1 | 15-06-2011 |
| | | | JP | 2012504844 A | 23-02-2012 |
| | | | KR | 20110082030 A | 15-07-2011 |
| | | | RU | 2011117180 A | 10-11-2012 |
| | | | TW | 201028029 A | 16-07-2010 |
| | | | US | 2011186905 A1 | 04-08-2011 |
| | | | WO | 2010038181 A1 | 08-04-2010 |
| WO 2012060260 | A1 | 10-05-2012 | JP | 2012216759 A | 08-11-2012 |
| | | | TW | 201220992 A | 16-05-2012 |
| | | | WO | 2012060260 A1 | 10-05-2012 |

EPO FORM P0459

For more details about this annex : see Official Journal of the European Patent Office, No. 12/82

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- WO 2012025847 A
- WO 2010036116 A